# FASCICULE DE BREVET EUROPEEN

(11) **EP 1 506 206 B1**
(45) Date de publication et mention de la délivrance du brevet: **21.07.2010**
(21) Numéro de dépôt: 03752819.7
(22) Date de dépôt: 15.05.2003
(51) Int. Cl.: C07F 1/08, C23C 16/18

(54) **PROCEDE POUR LE DEPOT DE CUIVRE SUR UN SUPPORT.**
VERFAHREN ZUR ABSCHEIDUNG VON KUPFER AUF EINEM TRÄGER
METHOD OF DEPOSITING COPPER ON A SUPPORT

(30) Priorité: 22.05.2002 FR 0206228
(43) Date de publication de la demande: 16.02.2005
(73) Titulaire: CENTRE NATIONAL DE LA RECHERCHE SCIENTIFIQUE, 75016 Paris Cédex (FR)
(72) Inventeur: DOPPELT, Pascal, F-93130 NOISY LE SEC (FR)
(74) Mandataire: Habasque, Etienne J. Jean-François
(86) Numéro de dépôt international: PCT/FR2003/001483
(87) Numéro de publication internationale: WO 2003/097651

(56) Documents cités:
- GB-A- 1 251 183
- CHI K M ET AL: "Chemistry of copper(I).beta.-diketonate complexes. VI. Synthesis, characterization and chemical vapor deposition of 2,2-dimethyl-6,6,7,7,8,8,8-heptafluoro-3,5 -octanedione (fod) copper(I) (fod)CuL complexes and the solid state structure of (fod)Cu(PMe3)" JOURNAL OF ORGANOMETALLIC CHEMISTRY, ELSEVIER-SEQUOIA S.A. LAUSANNE, CH, vol. 449, 1993, pages 181-189, XP002229352 ISSN: 0022-328X
- HAKANSSON* M ET AL: "Copper(I) complexes with conjugated dienes" JOURNAL OF ORGANOMETALLIC CHEMISTRY, ELSEVIER-SEQUOIA S.A. LAUSANNE, CH, vol. 602, no. 1-2, mai 2000 (2000-05), pages 5-14, XP004200823 ISSN: 0022-328X

## Description

L'invention concerne un procédé pour le dépôt de cuivre sur un support, notamment pour les circuits intégrés.

L'utilisation de cuivre pour réaliser des contacts électriques dans les circuits intégrés est justifiée par sa faible résistivité électrique et sa faible électromigration.

Il est connu de déposer des couches minces sur des supports par un procédé PVD (physical vapour deposition) ou par un procédé CVD (chemical vapour deposition). La CVD donne des dépôts plus réguliers car la première étape est une étape d'absorption qui n'est pas directionnelle.

Différents procédés de dépôt de couches de cuivre ont été proposés dans l'art antérieur mettant en oeuvre des précurseurs CuCl :
- J.C.A Boyens, et al., (S. Afr. J. Chem., 1986, 39(4) 229) décrivent un complexe ((COD)CuCl)₂ préparé par diffusion de SO₂ dans une solution de CuCl_{2·}2H₂O et de 1,5-cyclooctadiène (COD) dans l'éthanol. Le complexe est caractérisé par une structure radiocristalline obtenue à partir d'un monocristal, et il est utilisé dans les photoréactions.
- Par N. Bourhila, et al., [Appl. Surf. Sci. 91 (1-4)175-181 (1995)], on connaît l'utilisation de (CuCl)₃ pour le dépôt de films de Cu par CVD, dans un réacteur basse pression. Le procédé est une chloruration in situ de Cu par Cl₂ qui provoque le dépôt de cuivre par la réduction de Cu₃Cl₃ par l'hydrogène dans le réacteur. Le but des travaux était de trouver un précurseur de Cu susceptible de remplacer les précurseurs de Cu sous forme solide, qui posent un problème pour contrôler la pression de vapeur lors du dépôt. La solution proposée consiste à synthétiser le précurseur juste au-dessus de la surface sur laquelle Cu doit être déposé. L'inconvénient de ce procédé est qu'il dépose un film de Cu tant sur le support à recouvrir que sur les parois du réacteur qu'il faut ensuite "nettoyer".

D'autres procédés mettant en oeuvre des précurseurs du type dicétonate ont également été proposés :
- P. Doppelt, T. H. Baum, (MRS Bull. XIX (8) (1994) 41) proposent un procédé de dépôt de films de cuivre par CVD sur des supports pour la réalisation de contacts électriques dans les circuits intégrés, pour la réalisation de composants électroniques dont les lignes métalliques sont inférieures à 0,25 µm. Les précurseurs de cuivre-cités sont notamment des complexés dans lesquels Cu est coordiné par un groupe acétylacétonate (acac), un groupe trifluoroacétylacétonate (tfac), un groupe hexafluoroacétylacétonate (fac), et stabilisé par divers ligands, notamment des ligands COD ou DMCOD, (1,5-diméthyl-1,5-cyclooctadiène).
- FR-2,760,743 (ou US-A-6,130,345) décrit divers précurseurs de cuivre pour le dépôt de cuivre par CVD, notamment des complexes de coordination de Cu^{I} stabilisés par un ligand, dans lesquels Cu est coordiné par un β-dicétonate, notamment par un hexafluoroacétylacétonate, et stabilisé par divers ligands.
- Chen, et al., [Chem. Mat. 13, 3993 (2001)] décrivent des précurseurs de cuivre, du type dicétonate, stabilisés par 2-méthyl-1-hexèn-3-yne. Il s'agit notamment de Cu(acac)MHY, Cu(tfac)MHY, Cu(hfac)MHY, Cu(pfac)MHY. MHY est le 2-méthyl-hex-3-yne. Le procédé met en oeuvre un réacteur CVD basse pression, dans lequel un mélange de précurseur Cu(hfac)MHY (qui est un liquide) et de MHY pur (95/5) est injecté sous forme liquide. Compte tenu des proportions respectives des constituants, il ne s'agit pas d'une solution du complexe dans MHY. MHY sert simplement à diminuer la viscosité du complexe liquide.
- US-A-5096737 décrit l'utilisation de complexes du Cu^{I} comme précurseurs pour le dépôt de cuivre par CVD. Les complexes sont formés par Cu^{I} coordiné à un β-dicétonate et stabilités par un ligand. Le β-dicétonate peut être par exemple acac, tfac, hfac. Le ligand peut être un alcyne, une oléfine, un diène, une phosphine, par exemple COD ou DMCOD. Le précurseur (DMCOD(Cu^{I})(hfac) est introduit dans le réacteur CVD par bullage d'argon à travers le précurseur liquide.
- US-A-5,098,516 décrit un procédé de dépôt d'un film de cuivre sur un support, en mettant en contact ledit support à une température entre 110°C et 190°C avec un complexe organométallique de cuivre coordiné par un β-dicétonate (notamment hfac) stabilisé par un ligand. Le précurseur est choisi pour son caractère volatil et peut donc être introduit dans le réacteur sous forme gazeuse.
- US-A-5,085,731 et US-A-5,144,049 décrivent des complexes de cuivre, utilisables pour le dépôt de films de cuivre par CVD. Les complexes sont des complexes organométalliques liquides volatils coordinés par un acétylacétonate fluoré, et stabilités par un ligand. Pour la mise en oeuvre de la CVD, le précurseur est introduit dans le réacteur sous forme de vapeur de précurseur pur, ou entraîné par de l'argon vers le réacteur en faisant buller de l'argon à travers le précurseur liquide.

L'utilisation de ces complexes de cuivre coordiné par un β-dicétonate pour le dépôt de film de cuivre présente cependant un inconvénient majeur : les hétéroatomes contenus dans les ligands se retrouvent sous forme de polluants dans le film de cuivre déposé.

Il a en outre été proposé de déposer des films de cuivre par un procédé CVD à l'aide d'une solution de précurseur. Par exemple, WO98 00432 décrit un procédé de dépôt d'une couche de métal par CVD à partir d'une solution d'un complexe de platine à l'aide d'un injecteur liquide. Un tel procédé est intéressant sur le plan technique, mais il peut être mis en oeuvre uniquement avec des complexes précurseurs qui sont aisément solubles dans les solvants utilisables dans les injecteurs liquides.

Le but de la présente invention est de fournir un complexe de Cu, dans lequel le groupe de coordination ne contient pas d'hétéroatome gênant pour le dépôt du métal et qui soit soluble dans un solvant utilisable en CVD.

C'est pourquoi la présente invention a pour objet une composition d'un précurseur de cuivre, et un procédé pour le dépôt d'un film de cuivre sur un support à l'aide de ladite composition.

La composition de précurseur de cuivre selon l'invention est une composition d'un sel de cuivre dans un solvant organique liquide, et elle est caractérisée en ce que :
- le sel de cuivre est choisi parmi le chlorure de cuivre (I) et le bromure de cuivre (I)
- le solvant organique liquide est un composé non aromatique, non planaire, exempt d'hétéroatomes, qui présente au moins deux insaturations non conjuguées, et qui est choisi parmi :
   a) les composés non cycliques portant éventuellement au moins un groupe alkyle sur au moins l'un des atomes de carbone d'un groupe insaturé ;
   b) les composés cycliques comprenant deux insaturations sur le cycle, ledit cycle portant au moins un substituant alkyle ;
   c) les composés cycliques dans lesquels une insaturation fait partie du cycle et une insaturation est placée sur un substituant du cycle ;
   d) les composés cycliques dans lesquels deux insaturations sont placées sur le même substituant du cycle ou deux substituants différents.

Les compositions selon l'invention sont obtenues en introduisant le précurseur dans le solvant, et en laissant reposer pendant un certain temps. La durée dépend de la température à laquelle le milieu est maintenu. A titre d'exemple, une durée de 2 heures est suffisante lorsque la température est maintenue à 90°C.

Les compositions de CuCl ou de CuBr ainsi obtenues peuvent être utilisées avantageusement pour le dépôt de films de cuivre sur un support. Elles ont une concentration en sel de cuivre de préférence supérieure à 10⁻³ mole/l. La valeur supérieure limite est déterminée par la concentration à saturation, qui dépend essentiellement du solvant organique liquide et de la température.

Le procédé de dépôt d'un film de cuivre selon l'invention consiste à mettre en phase vapeur un précurseur de cuivre au contact d'un support chauffé, éventuellement en présence d'hydrogène, et il est caractérisé en ce que le précurseur de cuivre est CuCl ou CuBr utilisé sous forme d'une composition dans un solvant organique liquide, non aromatique, non planaire, exempt d'hétéroatomes, qui présente au moins deux insaturations non conjuguées, tel que défini ci-dessus.

Le complexe formé entré le sel du cuivre et le solvant est peu stable et il se décompose réversiblement en CuCl ou en CuBr et en solvant lorsque la composition est vaporisée.

Parmi les solvants définis ci-dessus, on préfère en particulier le 1,5-diméthyl-1,5-cyclooctadiène (DMCOD), le 4-vinyl-1-cyclohexène, le 2-méthyl-hex-3-yne (MHY), le 5-éthylidène-2-norbornène, le 1,2,4-trivinylcyclohexane.

Lors de la mise en oeuvre du procédé de dépôt de couches de cuivre sur un support, la composition contenant le précurseur de cuivre est envoyée dans un dispositif de vaporisation par l'intermédiaire duquel elle est introduite dans un réacteur à température élevée qui contient le support sur lequel la couche de cuivre doit être déposée. Avant son arrivée dans le dispositif de vaporisation, la composition est généralement maintenue dans un réservoir à température ambiante. La vaporisation de la composition de précurseur peut être effectuée à l'aide de divers dispositifs connus de l'homme de métier. A titre d'exemple préféré, on peut citer le dispositif décrit dans Chem. Mat. 13, 3993 (2001). Ledit dispositif, commercialisé par la société Jipelec sous le nom de "TriJet Liquid Precursor Delivery and Evaporation System", comprend trois parties principales : le réservoir, un injecteur et un évaporateur. La solution de chlorure ou bromure de cuivre (I) qui est située dans le réservoir maintenu à une pression de 1 bar, est propulsée grâce à l'injecteur par différence de pression dans l'évaporateur qui est maintenu sous vide. Le débit d'injection est contrôlé par une microélectrovanne commandée par un ordinateur. L'évaporateur ainsi que le reste du montage qui consiste principalement en une chambre de réaction pour un seul support, sont maintenus à la même température.

Un plasma froid peut éventuellement être ajouté autour du support. Lorsque le dépôt est effectué en présence de plasma, il est suffisant que le support destiné à recevoir la couche de cuivre soit maintenu à la même température qui règne dans le réacteur. En l'absence de plasma, il est nécessaire que ledit support soit à une température supérieure à celle du réacteur, la différence de température étant au moins égale à 20°C, de préférence au moins égale à 50°C, afin d'éviter le dépôt de cuivre sur les parois de réacteur.

Le' support peut être constitué par un matériau choisi notamment parmi Si, AsGa, InP, SiC et SiGe. La couche de cuivre peut être déposée sur ledit support comme première couche ou comme n^{ème} couche de métallisation pour les dispositifs électroniques nécessitant plusieurs niveaux de métallisation. Le support peut être constitué par l'un des matériaux précités pris tel quel, ou bien par l'un de ces matériaux portant une ou plusieurs couches intermédiaires. A titre d'exemple de couches intermédiaires, on peut citer les couches de diffusion constituées par un matériau choisi par exemple parmi TiN, TiSiN, Ta, TaN, TaSiN, WN et WSiN.

L'épaisseur de cuivre qui se dépose sur le support dépend de la concentration de la composition de précurseur, du débit de cette composition lors du passage dans le dispositif de vaporisation, de la durée de la vaporisation, des températures respectives dans le réacteur et sur le support. De manière générale, on utilise des compositions moins concentrées et/ou de débits plus faibles pour l'obtention de couches fines, et des compositions plus concentrées et/ou des débits plus élevés pour l'obtention de couches épaisses. Par couche fine, on entend généralement une couche ayant une épaisseur inférieure à ou égale à 50 nm, dite couche de nucléation. Par couche épaisse, on entend généralement une couche ayant une épaisseur entre 50 nm et 1 µm.

Pour l'obtention de couches épaisses, l'on peut utiliser les compositions dans un solvant à coefficient de dissolution élevée, à une concentration en précurseur proche de la saturation. La concentration doit rester inférieure à la valeur à saturation, afin d'éviter la reprécipitation du précurseur qui aurait pour effet de gêner la vaporisation.

Pour l'obtention de couches minces, on peut utiliser les solvants dans lesquels la solubilité du précurseur est plus faible. On peut également utiliser un liquide organique non solvant du précurseur et chimiquement inerte vis-à-vis du précurseur pour diluer une composition de précurseur selon l'invention. Par exemple, du toluène peut être utilisé pour diluer une composition de précurseur dans le DMCOD.

L'utilisation des compositions- selon l'invention pour l'élaboration de couches de cuivre par CVD permet d'obtenir des couches de cuivre de bonne qualité ayant une bonne adhérence au support sur lequel elles sont déposées.

L'invention est décrite plus en détail à l'aide des exemples suivants, qui sont donnés à titre d'illustration, mais auxquels l'invention n'est pas limitée.

### Exemple 1

### Préparation de compositions de CuCl

On a préparé des compositions de CuCl dans divers solvants. Pour chaque préparation, on a introduit CuCl sous atmosphère inerte d'azote dans un ballon équipé d'un réfrigérant. On a ensuite introduit 10 ml de solvant préalablement dégazé. La composition a ensuite été chauffée à 90°C pendant 2 heures.

La détermination de la quantité de complexe formé a été faite en filtrant la composition obtenue, en la versant dans 250 ml de pentane, et en pesant le précipité obtenu après filtration et séchage. Le solide resté dans le ballon a également été séché et pesé afin de vérifier le bilan massique. Les résultats obtenus sont donnés dans le tableau I.

**TABLEAU I**

| Masse CuCl (g) | Solvant | Masse du précipité (mg) | Solubilité mg/ml | Solubilité mole/l |
|---|---|---|---|---|
| 1,005 | DMCOD (diméthylcyclooctadiène) | 411 | 41,1 | 0,42 |
| 1,008 | 1,2,4- trivinylcyclohexane | 731,1 | 73,1 | 0,74 |
| 1,007 | 4-vinylcyclo-1-hexene | 189,1 | 18,91 | 0,19 |
| 1,002 | 2-methyl-hex-3-yne (MHY) | 594,4 | 59,4 | 0,60 |
| 1,015 | 5 ethylidene-2-, norbornene | 653 | 65,3 | 0,66 |

### Exemple 2

### Préparation de compositions de CuBr

Dans des conditions analogues à celles de l'exemple 1, on a préparé une composition de CuBr dans DMCOD. Les résultats sont donnés dans le tableau II.

**TABLEAU II**

| Masse CuBr (g) | Solvant | Masse du précipité (mg) | Solubilité mg/ml | Solubilité mole/l |
|---|---|---|---|---|
| 1,005 | DMCOD (diméthylcyclooctadiène) | 170 | 17 | 0,12 |

### Exemple 3

A l'aide d'une composition de CuCl dans DMCOD obtenu selon le procédé de l'exemple 1, on a déposé un film de cuivre sur un support maintenu à 350°C et placé dans un réacteur à 250°C sous une pression de 5 Torr. La composition de CuCl est envoyée dans un dispositif de vaporisation en même temps que de l'hydrogène gazeux. Le débit de l'hydrogène gazeux était de 150 ml/min.

Dans un premier essai, le support était une plaquette de silicium qui a un diamètre de 4 pouces et qui est recouverte d'un film de TiN ayant une épaisseur de 200 nm, et le débit de composition de précurseur était de 0,7 ml/min. Dans un second essai, le support était une plaquette de silicium qui a un diamètre de 8 pouces et qui est recouverte d'un film de TiN ayant une épaisseur de 200 nm, et le débit de composition de précurseur était de 2,7 ml/min.

On a obtenu dans chaque cas un film de cuivre adhérent de bonne qualité avec une vitesse de croissance de 20 nm/min.

## Revendications

1. Procédé de dépôt d'un film de cuivre sur un support, consistant à mettre en phase vapeur un précurseur de cuivre au contact du support chauffé, éventuellement en présence d'hydrogène, **caractérisé en ce que** le précurseur de cuivre est sous forme d'une composition d'un sel de cuivre dans un solvant organique liquide, dans laquelle :
- le sel de cuivre est choisi parmi le chlorure de cuivre (I) et le bromure de cuivre (I)
- le solvant organique liquide est un composé non aromatique, non planaire, exempt d'hétéroatomes, qui présente au moins deux insaturations non conjuguées, et qui est choisi parmi :
a) les composés non cycliques portant éventuellement au moins un groupe alkyle sur au moins l'un des atomes de carbone d'un groupe insaturé ;
b) les composés cycliques comprenant deux insaturations sur le cycle, ledit cycle portant au moins un'substituant alkyle ;
c) les composés cycliques dans lesquels une insaturation fait partie du cycle et une insaturation est placée sur un substituant du cycle ;
d) les composés cycliques dans lesquels deux insaturations sont placées sur le même substituant du cycle ou deux substituants différents.

2. Procédé selon la revendication 1, **caractérisé en ce que** le solvant organique liquide est choisi parmi le 1,5-diméthyl-1,5-cyclooctadiène (DMCOD), le 4-vinyl-1-cyclohexène, le 2-méthyl-hex-3-yne (MHY), le 5-éthylidène-2-norbornène, le 1,2,4-trivinylcyclohexane.

3. Procédé selon la revendication 1, **caractérisé en ce** la composition de précurseur contient en outre liquide organique non solvant du précurseur et chimiquement inerte vis-à-vis du précurseur.

4. Procédé selon la revendication 1, **caractérisé en ce que** la concentration en précurseur est supérieure à 10⁻³ mole/l.

5. Procédé selon la revendication 1, **caractérisé en ce que** la composition de précurseur de cuivre est envoyée dans un dispositif de vaporisation par l'intermédiaire duquel elle est introduite dans un réacteur à température inférieure à celle du support sur lequel la couche de cuivre est déposée.

6. Procédé selon la revendication 5, **caractérisé en ce que** l'écart de température entre le réacteur et le support est d'au moins 20°C.

7. Procédé selon la revendication 1, **caractérisé en qu'**on ajoute un plasma froid autour du support, la température du support étant au moins égale à la température du réacteur.

8. Procédé selon la revendication 1, **caractérisé en ce que** le support est constitué par un matériau choisi parmi Si, AsGa, InP, SiC et SiGe.

9. Procédé selon la revendication 8, **caractérisé en ce que** le support porte un couche intermédiaire.

10. Procédé selon la revendication 9, **caractérisé en ce que** la couche intermédiaire est constituée par un matériau choisi parmi TiN, TiSiN, Ta, TaN, TaSiN, WN et WSiN.

## Claims

1. A method of depositing a copper film onto a support, consisting of putting a copper precursor in vapour phase in contact with the heated support, possibly in the presence of hydrogen, **characterised in that** the copper precursor is in the form of a copper salt composition in a liquid organic solvent, wherein:
- the copper salt is chosen from copper chloride (I) and copper bromide (I)
- the liquid organic solvent is a non-aromatic, non-planar compound, free from heteroatoms, which has at least two non-conjugated unsaturations, and which is chosen from:
a) the non-cyclic compounds possibly carrying at least one alkyl group on at least one of the carbon atoms of an unsaturated group;
b) the cyclic compounds comprising two unsaturations on the cycle, said cycle carrying at least one alkyl substituent;
c) the cyclic compounds wherein one unsaturation forms part of the cycle and one unsaturation is placed on a substituent of the cycle;
d) the cyclic compounds wherein two unsaturations are placed on the same substituent of the cycle or two different substituents.

2. The method according to Claim 1, **characterised in that** the liquid organic solvent is chosen from 1,5-dimethyl-1,5-cyclooctadiene (DMCOD), 4-vinyl-1-cyclohexene, 2-methyl-hex-3-yne (MHY), 5-ethylidene-2-norbornene, 1,2,4-trivinytcyclohexane.

3. The method according to Claim 1, **characterised in that** the precursor composition further contains non-solvent organic liquid of the precursor which is chemically inert in relation to the precursor.

4. The method according to Claim 1, **characterised in that** the precursor concentration is greater than 10⁻³ mole/l.

5. The method according to Claim 1, **characterised in that** the copper precursor composition is passed into a vaporisation device by means of which it is introduced into a reactor at a temperature lower than that of the support on which the layer of copper is being deposited.

6. The method according to Claim 5, **characterised in that** the difference in temperature between the reactor and the support is at least 20°C.

7. The method according to Claim 1, **characterised in that** a cold plasma is added around the support, the temperature of the support being at least equal to the temperature of the reactor.

8. The method according to Claim 1, **characterised in that** the support is formed by a material chosen from Si, AsGa, InP, SiC and SiGe.

9. The method according to Claim 8, **characterised in that** the support carries an intermediate layer.

10. The method according to Claim 9, **characterised in that** the intermediate layer is formed by a material chosen from TiN, TiSiN, Ta, TaN, TaSiN, WN and WSiN.

## Patentansprüche

1. Verfahren zum Abscheiden eines Kupferfilms auf einem Träger, das darin besteht, einen Kupferpräkursor in der Dampfphase mit dem erwärmten Träger optional in Anwesenheit von Wasserstoff in Kontakt zu bringen, **dadurch gekennzeichnet, dass** der Kupferpräkursor in Form einer Zusammensetzung aus einem Kupfersalz in einem flüssigen organischen Lösungsmittel ist, wobei:
- das Kupfersalz aus Kupfer-(I)-chlorid und Kupfer-(I)-bromid ausgewählt ist,
- das flüssige organische Lösungsmittel eine nicht-aromatische, nichtplanare, heteroatomfreie Verbindung ist, die mindestens zwei nicht-konjugierte Ungesättigtheiten aufweist, und die ausgewählt ist aus:
a) den nicht-zyklischen Verbindungen, die optional mindestens eine Alkylgruppe auf mindestens einem der Kohlenstoffatome einer ungesättigten Gruppe tragen,
b) den zyklischen Verbindungen, die zwei Ungesättigtheiten auf dem Ring aufweisen, wobei der Ring mindestens einen Alkylsubstituenten trägt,
c) den zyklischen Verbindungen, bei denen eine Ungesättigtheit Teil des Ringes ist und eine Ungesättigtheit auf einem Substituenten des Ringes platziert ist,
d) den zyklischen Verbindungen, bei denen zwei Ungesättigtheiten auf demselben Substituenten des Ringes oder auf zwei verschiedenen Substituenten platziert sind.

2. Verfahren gemäß Anspruch 1, **dadurch gekennzeichnet, dass** das flüssige organische Lösungsmittel aus 1,5-Dimethyl-1,5-cyclooctadien (DMCOD), 4-Vinyl-1-cyclohexen, 2-Methyl-hex-3-in (MHY), 5-Ethyliden-2-norbornen, 1,2,4-Trivinylcyclohexan ausgewählt ist.

3. Verfahren gemäß Anspruch 1, **dadurch gekennzeichnet, dass** die Präkursorzusammensetzung ferner eine organische Flüssigkeit aufweist, die ein Nichtlösungsmittel des Präkursors ist und dem Präkursor gegenüber chemisch inert ist.

4. Verfahren gemäß Anspruch 1, **dadurch gekennzeichnet, dass** die Präkursorkonzentration größer als 10⁻³ Mol/l ist.

5. Verfahren gemäß Anspruch 1, **dadurch gekennzeichnet, dass** die Kupferpräkursorzusammensetzung in eine Verdampfungsvorrichtung geleitet wird, mittels welcher sie in einen Reaktor mit einer Temperatur, die niedriger als die des Trägers ist, auf den die Kupferschicht abgeschieden wird, eingeführt wird.

6. Verfahren gemäß Anspruch 5, **dadurch gekennzeichnet, dass** die Abweichung der Temperatur zwischen dem Reaktor und dem Träger mindestens 20°C beträgt.

7. Verfahren gemäß Anspruch 1, **dadurch gekennzeichnet, dass** um den Träger herum ein kaltes Plasma hinzugefügt wird, wobei die Temperatur des Trägers mindestens gleich der Temperatur des Reaktors ist.

8. Verfahren gemäß Anspruch 1, **dadurch gekennzeichnet, dass** der Träger aus einem aus Si, AsGa, InP, SiC und SiGe ausgewählten Material aufgebaut ist.

9. Verfahren gemäß Anspruch 8, **dadurch gekennzeichnet, dass** der Träger eine Zwischenschicht trägt.

10. Verfahren gemäß Anspruch 9, **dadurch gekennzeichnet dass** die Zwischenschicht aus einem aus TiN, TiSiN, Ta, TaN, TaSiN, WN und WSiN ausgewählten Material aufgebaut ist.
